(19) Europäisches Patentamt
European Patent Office
Office européen des brevets

(11) **EP 3 200 228 B1**

(12) **EUROPEAN PATENT SPECIFICATION**

(45) Date of publication and mention of the grant of the patent:
**27.02.2019 Bulletin 2019/09**

(51) Int Cl.:
**H01L 27/02** (2006.01)   **H02H 9/04** (2006.01)
**H01L 29/78** (2006.01)

(21) Application number: **16199515.4**

(22) Date of filing: **18.11.2016**

(54) **ELECTROSTATIC DISCHARGE PROTECTION CIRCUIT WITH LEAKAGE CURRENT REDUCTION AND ASSOCIATED ELECTROSTATIC DISCHARGE PROTECTION METHOD**

SCHUTZSCHALTUNG GEGEN ELEKTROSTATISCHE ENTLADUNG MIT LECKSTROMVERRINGERUNG UND ZUGEHÖRIGES VERFAHREN ZUM SCHUTZ GEGEN ELEKTROSTATISCHE ENTLADUNG

CIRCUIT DE PROTECTION CONTRE LA DÉCHARGE ÉLECTROSTATIQUE À RÉDUCTION DE COURANT DE FUITE ET PROCÉDÉ ASSOCIÉ DE PROTECTION CONTRE LES DÉCHARGES ÉLECTROSTATIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.01.2016 US 201662288497 P**
**16.11.2016 US 201615353702**

(43) Date of publication of application:
**02.08.2017 Bulletin 2017/31**

(73) Proprietor: **MediaTek Inc.**
**Hsin-Chu 300 (TW)**

(72) Inventors:
• **WANG, Chang-Tzu**
**Taoyuan City 326 (TW)**
• **YANG, Tzu-Yi**
**Hsinchu City 300 (TW)**

(74) Representative: **Hoefer & Partner Patentanwälte mbB**
**Pilgersheimer Straße 20**
**81543 München (DE)**

(56) References cited:
**US-A1- 2006 072 267**   **US-A1- 2008 297 960**
**US-A1- 2013 027 820**   **US-A1- 2014 063 665**

## Description

The present invention relates to an electrostatic discharge (ESD) protection circuit, and more particularly, to an ESD protection circuit according to the pre-characterizing clause of claim 1. Such an ESD protection circuit is disclosed in US 2013/027820 A1. A similar ESD protection is also known from US 2008/0297960 A1, US 2006/0072267 A1 and US 2014/0063665 A1.

Electrostatic discharge (ESD) protection becomes more challenging in the nanoscale CMOS process due to the thinner gate oxide and shallower junction depth. A typical ESD protection circuit may have an N-channel metal-oxide semiconductor (NMOS) transistor serving as a power clamp circuit coupled between a supply voltage and a ground voltage. For example, the leakage current of the power clamp circuit in the typical 1.8V ESD protection circuit fabricated using a planar CMOS process may be ~7nA during a normal mode. However, when the same ESD protection circuit is fabricated using a Fin Field-Effect Transistor (FinFET) process, the leakage current of the power clamp circuit may increase significantly. The main leakage current is the junction leakage from the drain-to-bulk (N+/P-well junction) of a FinFET (which acts as the power clamp circuit), where the drain-to-bulk leakage of the FinFET is proportional to the drain-to-gate voltage of the FinFET. For example, the leakage current of the power clamp cell in the typical 1.8V ESD protection circuit fabricated using a FinFET process may be ~500nA during a normal mode. In general, there will be lots of 1.8V ESD protection circuits for input/output (I/O) ESD protection. The total leakage current caused by power clamp circuits fabricated using the FinFET process cannot be ignored.

Since the leakage issue is a problem for ESD protection, there is a need for an innovative ESD protection circuit design which can effectively reduce the leakage current in the normal mode.

One of the objectives of the claimed invention is to provide an ESD protection circuit with leakage current reduction and an associated ESD protection method.

The above-mentioned objective is achieved by an ESD protection circuit according to claim 1 and by an ESD protection method according to claim 9.

According to a first aspect of the present invention, an exemplary electrostatic discharge (ESD) protection circuit is disclosed. The exemplary ESD protection circuit includes an ESD detection circuit, an ESD clamp circuit, and a leakage current reduction circuit. The ESD detection circuit is configured to detect occurrence of an ESD event in a normal mode, wherein the ESD detection circuit generates an ESD trigger signal when the ESD event is detected. The ESD clamp circuit is configured to perform a discharge operation in response to the ESD trigger signal in an ESD mode. The ESD clamp circuit comprises a first transistor and a second transistor. The first transistor has a first connection terminal coupled to a first power rail, a control terminal, and a second connection terminal, wherein a bias voltage is supplied to the control terminal of the first transistor in the normal mode. The second transistor has a first connection terminal coupled to the second connection terminal of the first transistor, a control terminal, and a second connection terminal coupled to a second power rail, wherein the ESD trigger signal is transmitted to the control terminal of the second transistor. The leakage current reduction circuit is configured to provide the bias voltage to the first transistor.

According to a second aspect of the present invention, an exemplary electrostatic discharge (ESD) protection method is disclosed. The exemplary ESD protection method includes: detecting occurrence of an ESD event in a normal mode; when the ESD event is detected, generating an ESD trigger signal for triggering an ESD clamp circuit to perform a discharge operation in an ESD mode, wherein the ESD clamp circuit comprises: a first transistor, having a first connection terminal coupled to a first power rail, a control terminal, and a second connection terminal; and a second transistor, having a first connection terminal coupled to the second connection terminal of the first transistor, a control terminal, and a second connection terminal coupled to a second power rail, wherein the ESD trigger signal is transmitted to the control terminal of the second transistor; and in the normal mode, supplying a bias voltage to the control terminal of the first transistor for leakage current reduction.

In the following, the invention is further illustrated by way of example, taking reference to the accompanying drawings .

FIG. 1 is a block diagram illustrating an electrostatic discharge (ESD) protection circuit according to an embodiment of the present invention,

FIG. 2 is a circuit diagram illustrating a first ESD protection circuit according to an embodiment of the present invention,

FIG. 3 is a circuit diagram illustrating a second ESD protection circuit according to an embodiment of the present invention, and

FIG. 4 is a circuit diagram illustrating a third ESD protection circuit according to an embodiment of the present invention.

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ... ". Also, the term "couple" is intended to mean either an indirect or direct electrical connection. Accordingly, if one device is coupled to another device, that connection may be through a direct electrical connection, or through an indirect electrical connection via other devices and connections.

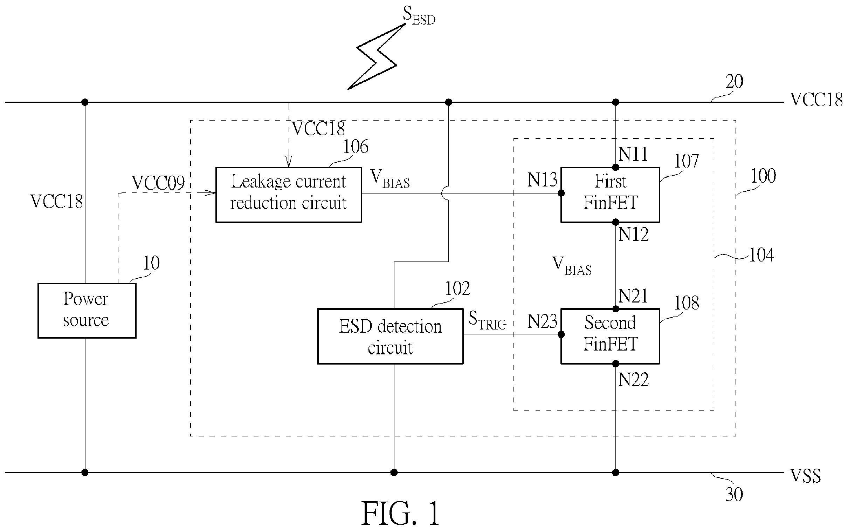

FIG. 1 is a block diagram illustrating an electrostatic discharge (ESD) protection circuit according to an embodiment of the present invention. The ESD protection circuit 100 is coupled between a first power rail 20 and a second power rail 30. In this embodiment, a reference voltage supplied by the first power rail 20 is a supply voltage VCC18 (e.g., 1.8V), and a reference voltage supplied by the second power rail 30 is a ground voltage VSS (e.g., 0V). As shown in FIG. 1, the supply voltage VCC18 is generated from a power source 10 of a processing system. It should be noted that the processing system may be implemented in an integrated circuit, and may include more than one ESD protection circuit 100 and other processing circuits. Hence, the power source 10 of the processing system may further provide other reference voltages to certain processing circuits. For example, the power source 10 may further generate a different supply voltage VCC09 (e.g., 0.9V).

The ESD detection circuit 102 is configured to detect occurrence of an ESD event SESD in a normal mode of the ESD protection circuit 100. The ESD detection circuit 102 generates an ESD trigger signal STRIG when the ESD event SESD on the first power rail 20 is detected. In addition, the ESD protection circuit 100 leaves the normal mode and enters an ESD mode after the ESD trigger signal STRIG is generated (e.g., the ESD trigger signal STRIG is asserted upon occurrence of the ESD event SESD), and leaves the ESD mode and enters the normal mode after the ESD trigger signal STRIG is not generated (e.g., the ESD trigger signal STRIG is de-asserted after a pre-defined period of time has been elapsed since the occurrence of the ESD event SESD).

The ESD clamp circuit 104 is configured to perform a discharge operation in response to the ESD trigger signal STRIG in the ESD mode of the ESD protection circuit 100, thereby discharging large current induced by the ESD event SESD to the ground. In this embodiment, the ESD protection circuit 100 is fabricated using a Fin Field-Effect Transistor (FinFET) process. Hence, the ESD clamp circuit 104 includes a plurality of FinFETs (e.g., first FinFET 107 and second FinFET 108) cascoded between the first power rail 20 and the second power rail 30. The first FinFET 107 has a first connection terminal N11, a second connection terminal N12, and a control terminal N13. Similarly, the second FinFET 108 has a first connection terminal N21, a second connection terminal N22, and a control terminal N23. As for the first FinFET 107, the first connection terminal N11 is coupled to the first power rail 20, and the second terminal N12 is coupled to the first terminal N21 of the second FinFET 108. As for the second FinFET 108, the first connection terminal N21 is coupled to the second connection terminal N12 of the first FinFET 107, and the second terminal N22 is coupled to the second power rail 30. In addition, a bias voltage VBIAS is supplied to the control terminal (i.e., gate terminal) N13 of the first FinFET 107 in the normal mode, and the ESD trigger signal STRIG generated due to the detected ESD event SESD is transmitted to the control terminal (i.e., gate terminal) N23 of the second FinFET 108. However, the configuration of the ESD clamp circuit shown in FIG. 1 is for illustrative purposes only, and is not meant to be a limitation of the present invention. Any ESD clamp circuit design that has cascoded transistors including a first transistor with a control terminal biased by a bias voltage in the normal mode for leakage current reduction and a second transistor with a control terminal configured to receive an ESD trigger signal for ESD mode activation falls within the scope of the present invention.

The leakage current reduction circuit 106 is configured to provide the bias voltage VBIAS to the first FinFET 107 for reducing the current leakage of the first FinFET 107 in the normal mode. The ESD clamp circuit 104 should be disabled in the normal mode. However, as shown in FIG. 1, the reference voltage VCC18 (e.g., 1.8V) is always applied to the first connection terminal N11 of the first FinFET 107 in the normal mode. Since the junction leakage of the first FinFET 107 is proportional to a voltage difference between a voltage at the first connection terminal N11 and a voltage at the control terminal N13, the present invention therefore proposes supplying the bias voltage VBIAS to the control terminal N13 of the first FinFET 107 to reduce the voltage difference between the voltage at the first connection terminal N11 and the voltage at the control terminal N13, thereby mitigating the junction leakage of the first FinFET 107 in the normal mode.

The bias voltage VBIAS is between the reference voltages VCC18 and VSS. For example, the bias voltage VBIAS is intentionally controlled to fall within a voltage range from 0.25*VCC18 to 0.75*VCC18, where VCC18 is a supply voltage, and VSS is a ground voltage. In one exemplary design, the current leakage reduction circuit 106 may receive the reference voltage VCC18 and generate the bias voltage VBIAS according to the reference voltage VCC18, where VBIAS<VCC18. In another exemplary design, the current leakage reduction circuit 106 may receive the reference voltage VCC09 and directly set the bias voltage VBIAS by VCC09 (i.e., VBIAS=VCC09).

It should be noted that the bias voltage VBIAS should be properly controlled to ensure that the total leakage current of the ESD clamp circuit 104 can meet the requirement. In the normal mode, the second FinFET 108 is not turned on. However, the voltage at the first connection terminal N21 of the second FinFET 108 is correlated to the bias voltage VBIAS supplied to the control terminal N13 of the first FinFET 107. For example, the voltage VN21 at the first connection terminal N21 of the second FinFET 108 may be approximately lower than the bias voltage VBIAS at the control terminal N13 of the first FinFET 107 by a threshold voltage Vth of the first FinFET 107, namely $V_{N21} = V_{BIAS} - V_{th}$. Like the first FinFET 107, the second FinFET 108 may suffer from junction leakage resulting from a voltage difference between a voltage at the control terminal N23 and the voltage VN21 at the first connection terminal N21. The leakage current of the first FinFET 107 and the leakage current of the second FinFET 108 both contribute to the total leakage current of the ESD clamp circuit 104. The junction leakage of the first FinFET 107 is inverse proportional to the supplied bias voltage VBIAS, and the junction leakage of the second FinFET 108 is proportional to the supplied bias voltage VBIAS. If the bias voltage VBIAS is lower than a particular voltage level, the total leakage current of the ESD clamp circuit 104 is dominated by the leakage current of the first FinFET 107. If the bias voltage VBIAS is higher than the particular voltage level, the total leakage current of the ESD clamp circuit 104 is dominated by the leakage current of the second FinFET 106. In one exemplary implementation, the bias voltage VBIAS is intentionally controlled to fall within a voltage range from 0.25*VCC18 to 0.75*VCC18, such that total leakage current of the ESD clamp circuit 104 is ensured to be lower than an acceptable level for meeting the requirement. For example, when VBIAS=0.5*VCC18, the total leakage current of the ESD clamp circuit 104 in the ESD protection circuit 100 fabricated using the FinFET process may be ~55nA which is much smaller than ~500nA leakage in the typical 1.8V ESD protection circuit fabricated using the FinFET process . For another example, when VBIAS=0.45*VCC18, the total leakage current of the ESD clamp circuit 104 in the ESD protection circuit 100 fabricated using the FinFET process may be ~33nA which is much smaller than ~500nA in the typical 1.8V ESD protection circuit fabricated using the FinFET process. These experiment results shown that an ESD protection circuit can have lower leakage by using the proposed leakage current reduction design.

Since the reference voltage VCC09 (e.g., 0.9V) is already available in the processing system, the implementation of the leakage current reduction circuit 106 can be simplified by directly using the available reference voltage VCC09 to serve as the bias voltage VBIAS. Since the reference voltage VCC09 (VCC09=0.5*VCC18) is within a voltage range from 0.25*VCC18 to 0.75*VCC18, the same objective of reducing the leakage current of the ESD clamp circuit is achieved. However, using a leakage current reduction circuit that is only capable of outputting the reference voltage VCC09 as the bias voltage VBIAS is for illustrative purposes only, and is not meant to be a limitation of the present invention. For example, any leakage current reduction circuit design that can be configured to provide the bias voltage VBIAS within a required voltage range, for example, from 0.25*VCC18 to 0.75*VCC18 may be employed by the ESD protection circuit 100. This also falls within the scope of the present invention.

As mentioned above, the ESD clamp circuit 104 should be disabled in the normal mode. For example, when there is no ESD event SESD affecting the supply voltage on the first power rail 20, the ESD protection circuit 100 does not need to enable the ESD clamp circuit 104 for creating a discharging path between the first power rail 20 and the second power rail 30. However, it is possible that the bias voltage VBIAS is set by a voltage level that is higher than the threshold voltage Vth (e.g., 0.7V) of the first FinFET 107. Hence, the first FinFET 107 may be always turned on in the normal mode. For example, in a case where VBIAS=0.5*VCC18=VCC09, the first FinFET 107 is turned on, regardless of occurrence of the ESD event SESD. To ensure that the ESD clamp circuit 104 is always disabled in the normal mode, the second FinFET 108 is implemented to ensure that the discharging path between the first power rail 20 and the second power rail 30 is cut off in the normal mode. That is, before the ESD trigger signal STRIG is generated in response to the ESD event SESD, the second FinFET 108 is turned off, thereby preventing the ESD clamp circuit 104 from being enabled in the normal mode.

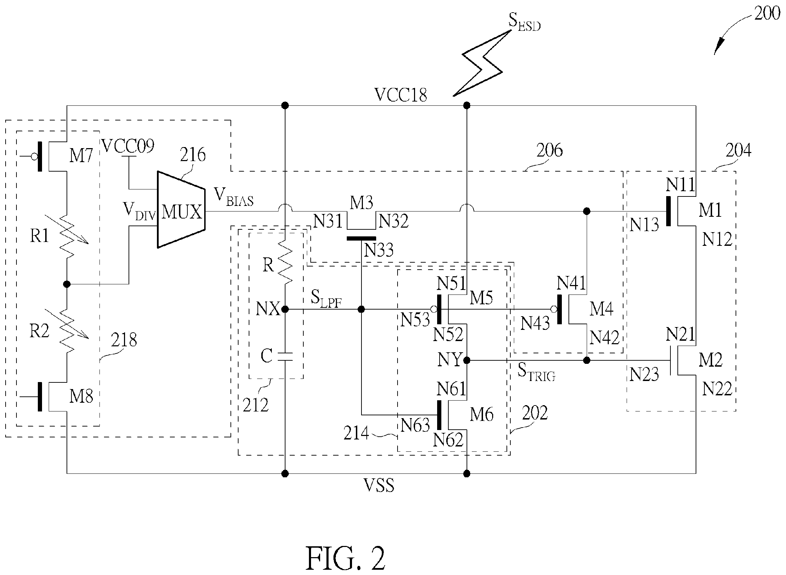

FIG. 2 is a circuit diagram illustrating a first ESD protection circuit according to an embodiment of the present invention. The ESD protection circuit 200 is implemented using the configuration shown in FIG. 1, and therefore includes an ESD detection circuit 202, an ESD clamp circuit 204, and a leakage current reduction circuit 206. The ESD detection circuit 202 is a resistor-capacitor (RC) based trigger circuit, and has a low-pass filter 212 and an inverter 214. The low-pass filter 212 is a 1st-order low-pass filter composed of a resistor R and a capacitor C that are connected in series between the reference voltages VCC18 and VSS, where a filter output SLPF is generated at a filter output node NX of the low-pass filter 212. The inverter 214 is composed of a P-channel metal-oxide-semiconductor (PMOS) transistor M5 and an N-channel metal-oxide-semiconductor (PMOS) transistor M6. The PMOS transistor M5 has a first connection terminal N51, a second connection terminal N52, and a control terminal N53. The NMOS transistor M6 has a first connection terminal N61, a second connection terminal N62, and a control terminal N63. As for the PMOS transistor M5, the first connection terminal N51 is coupled to the reference voltage VCC18, the control terminal N53 is configured to receive the filter output SLPF, and the second connection terminal N52 is coupled to the first connection terminal N61 of the NMOS transistor M6. As for the NMOS transistor M6, the first connection terminal N61 is coupled to the second connection terminal N52 of the PMOS transistor M5, the control terminal N63 is configured to receive the filter output SLPF, and the second connection terminal N62 is coupled to the reference voltage VSS.

The ESD clamp circuit 204 includes two NMOS transistors M1 and M2 cascoded between the reference voltages VCC18 and VSS. The NMOS transistor M1 has a first connection terminal N11, a second connection terminal N12, and a control terminal N13. The NMOS transistor M2 has a first connection terminal N21, a second connection terminal N22, and a control terminal N23. As for the NMOS transistor M1, the first connection terminal N11 is coupled to the reference voltage VCC18, the control terminal N13 is configured to receive the bias voltage VBIAS in the normal mode, and the second connection terminal N12 is coupled to the first connection terminal N21 of the NMOS transistor M2. As for the NMOS transistor M2, the first connection terminal N21 is coupled to the second connection terminal N12 of the NMOS transistor M1, the control terminal N23 is coupled to an inverter output node NY and is configured to receive the ESD trigger signal STRIG generated/asserted in response to the ESD event SESD, and the second connection terminal N22 is coupled to the reference voltage VSS.

The leakage current reduction circuit 206 includes an NMOS transistor M3, a PMOS transistor M4, a multiplexer (MUX) 216, and a voltage divider 218. The NMOS transistor M3 has a first connection terminal N31, a second connection terminal N32, and a control terminal N33. The NMOS transistor M4 has a first connection terminal N41, a second connection terminal N42, and a control terminal N43. As for the NMOS transistor M3, the first connection terminal N31 is coupled to an output port of the multiplexer 216, the second connection terminal N32 is coupled to the control terminal N13 of the NMOS transistor M1, and the control terminal N33 is configured to receive the filter output SLPF. As for the PMOS transistor M4, the first connection terminal N41 is coupled to the control terminal N13 of the NMOS transistor M1, the second connection terminal N42 is coupled to the control terminal N23 of the NMOS transistor M2, and the control terminal N43 is configured to receive the filter output SLPF.

As shown in FIG. 2, the leakage current reduction circuit 206 supports two bias voltage generation schemes. When a first bias voltage generation scheme is selected, the reference voltage VCC09 (e.g., 0.9V) generated from a power source (e.g., the power source 10 shown in FIG. 1) and received by one input port of the multiplexer 216 is output by the multiplexer 216 to serve as the bias voltage VBIAS. In other words, VBIAS=VCC09. When a second bias voltage generation scheme is selected, a divided voltage VDIV generated from the voltage divider 218 and received by the other input port of the multiplexer 216 is output by the multiplexer 216 to serve as the bias voltage VBIAS. In this embodiment, the voltage divider 218 includes a plurality of variable resistors R1, R2, a PMOS transistor M7, and an NMOS transistor M8. When the second bias voltage generation scheme is selected, the PMOS transistor M7 and the NMOS transistor M8 are turned on, and the variable resistors R1 and R2 are properly controlled to generate the divided voltage VDIV to the multiplexer 216.

That is, $V_{BIAS} = V_{DIV} = VCC18 \times \dfrac{R1}{R1+R2}$. For example, assuming that the reference voltage VCC18 is a supply voltage (e.g., 1.8V) and the reference voltage VSS is a ground voltage (e.g., 0V), the variable resistors R1 and R2 can be adjusted to make the divided voltage VDIV fall within a voltage range from 0.25*VCC18 to 0.75*VCC18.

Alternatively, the leakage current reduction circuit 206 may be modified to support only one of the bias voltage generation schemes. For example, the multiplexer 216 and the voltage divider 218 may be omitted, and the reference voltage VCC09 may be used to directly set the bias voltage VBIAS. For another example, the multiplexer 216 may be omitted, the reference voltage VCC09 may not be supplied to the leakage current reduction circuit 206, and the divided voltage VDIV derived from a voltage dividing operation performed upon the reference voltage VCC18 received from a power source (e.g., the power source 10 shown in FIG. 1) may be used to set the bias voltage VBIAS. These alternative designs all fall within the scope of the present invention.

When the ESD protection circuit 200 operates in a normal node (i.e., there is no ESD event SESD detected by the ESD detection circuit 202), the low-pass filter 212 processes the reference voltage VCC18 to generate the filter output SLPF at the filter output node NX. Hence, the filter output SLPF may be regarded as having a logic high level. Since the filter output SLPF is supplied to the control terminal N33 of the NMOS transistor M3, the NMOS transistor N33 is turned on to transmit the bias voltage VBIAS to the control node N13 of the NMOS transistor M1, thereby achieving leakage current reduction of the NMOS transistor M1 as mentioned above. Since the filter output SLPF is also supplied to the control terminal N43 of the PMOS transistor M4, the PMOS transistor M4 is turned off. In addition, the filter output SLPF is an input of the inverter 214. Hence, the PMOS transistor M5 is turned off, and the NMOS transistor M6 is turned on. The voltage level at the inverter output node NY may be regarded as having a logic low level. The NMOS transistor M2 is turned off. Though the NMOS transistor M1 may be turned on by the bias voltage VBIAS, the ESD clamp circuit 204 is disabled due to the NMOS transistor M2 being turned off.

When the ESD event SESD occurs, the reference voltage VCC18 rises quickly. However, due to the RC constant possessed by the low-pass filter 212, the voltage level of the filter output node NX is temporarily maintained at the time the ESD event SESD occurs. The PMOS transistor M5 is turned on because there is a large voltage difference between voltages at the first connection terminal N51 and the control terminal N53 of the PMOS transistor M5. The voltage level at the inverter output node NY is pulled high to thereby generate/assert the ESD trigger signal STRIG to the control terminal N23 of the NMOS transistor M2. The NMOS transistor M2 is turned on. In addition, the PMOS transistor M4 is turned on due to a large voltage difference between voltages at the second connection terminal N42 and the control terminal N43 of the PMOS transistor M4. The boosted reference voltage VCC18 is transmitted by the PMOS transistor M4 to pull high the voltage level at the control terminal N13 of the NMOS transistor M1. In the ESD mode, the ESD clamp circuit 204 is enabled to crease a discharging path for discharging large current induced by the ESD event SESD to the ground. After the voltage level of the filter output node NX is increased via the low-pass filter 212, the PMOS transistor M5 is turned off, and the voltage level at the inverter output node NY is pulled low, such that the ESD trigger signal STRIG is de-asserted. At this moment, the ESD protection circuit 200 leaves the ESD mode and enters the normal mode again.

In one embodiment, the NMOS transistors M1, M2, M3, M6, M8 and PMOS transistors M4, M5, M7 are fabricated using the FinFET process. In other words, each of the NMOS transistors M1, M2, M3, M6, M8 and PMOS transistors M4, M5, M7 is one FinFET. As shown in IG. 3, each of the NMOS transistors M1, M3, M6, M8 and PMOS transistors M4, M5, M7 is a thick gate oxide transistor (e.g., an I/O device), and the NMOS transistor M2 is a thin gate oxide transistor (e.g., a core device) . In other words, a gate oxide thickness of each of the NMOS transistors M1, M3, M6, M8 and PMOS transistors M4, M5, M7 is larger than a gate oxide thickness of the NMOS transistor M2. The NMOS transistor M2 is a part of the ESD clamp circuit 204. Compared to a FinFET with a thick gate oxide, a FinFET with a thin gate oxide does not suffer from the junction leakage severely. Therefore, compared to the NMOS transistor M2 implemented using a thick gate oxide FinFET, the NMOS transistor M2 implemented using a thin gate oxide FinFET may have less impact on the leakage performance of the ESD clamp circuit 204 in the normal mode. Further, assuming that the transistor size is the same, a driving capability of a FinFET with a thin gate oxide is stronger than a driving capability of a FinFET with a thick gate oxide. Hence, compared to the NMOS transistor M2 implemented using a thick gate oxide FinFET, the NMOS transistor M2 implemented using a thin gate oxide FinFET may make the ESD clamp circuit 204 have better discharging performance in the ESD mode. However, this is for illustrative purposes only, and is not meant to be a limitation of the present invention. In an alternative design, the NMOS transistor M2 is not limited to a thin gate oxide transistor.

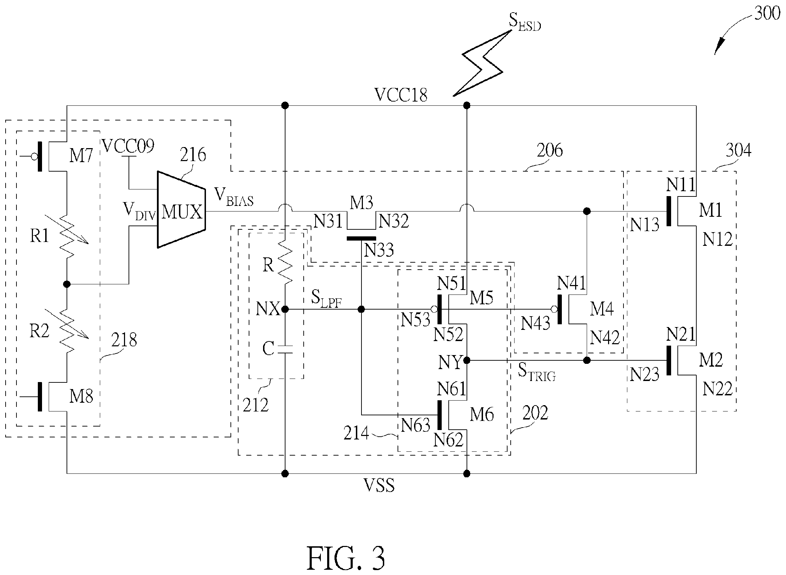

FIG. 3 is a circuit diagram illustrating a second ESD protection circuit according to an embodiment of the present invention. The ESD protection circuit 300 is implemented using the configuration shown in FIG. 1. The major difference between the ESD protection circuits 200 and 300 is that an ESD clamp circuit 304 includes two NMOS transistors M1 and M2, each implemented using a FinFET with a thick gate oxide. In other words, a gate oxide thickness of the NMOS transistor M1 is equal to a gate oxide thickness of the NMOS transistor M2. In this embodiment, the leakage current of the NMOS transistor M1 in the normal mode can be reduced by the bias voltage VBIAS and the NMOS transistor M2 ensures that the ESD clamp circuit 304 is disabled in the normal mode. Since a person skilled in the art can readily understand the operation of the ESD protection circuit 300 after reading above paragraphs directed to the ESD protection circuit 200, further description is omitted here for brevity.

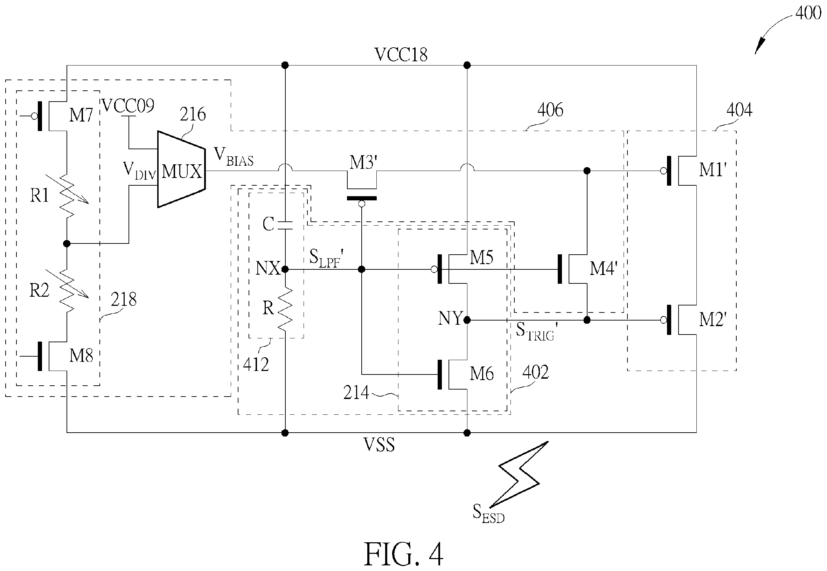

FIG. 4 is a circuit diagram illustrating a third ESD protection circuit according to an embodiment of the present invention. The major difference between the ESD protection circuit 200/300 and the ESD protection circuit is that an ESD clamp circuit 404 includes two PMOS transistors M1' and M2' cascoded between the reference voltages VCC18 and VSS. Since the ESD clamp circuit 404 is required to be disabled in the normal mode and to be enabled in the ESD mode, the ESD detection circuit 402 and the leakage current reduction circuit 406 should be properly designed. The leakage current reduction circuit 406 may be formed by replacing the NMOS transistor M3 in the leakage current reduction circuits 206 with a PMOS transistor M3' and replacing the PMOS transistor M4 in the leakage current reduction circuits 206 with an NMOS transistor M4. The ESD detection circuit 402 can be formed by replacing the low-pass filter 212 in the ESD detection circuit 202 with a low-pass filter 412, where the low-pass filter 412 has the capacitor C coupled between the reference voltage VCC18 and the filter output node NX, and has the resistor R coupled between the filter output node NX and the reference voltage VSS. When the ESD protection circuit 200 operates in a normal node (i.e., there is no ESD event detected by the ESD detection circuit 402), the filter output SLPF' generated from the filter output node NX has a logic low level, and a voltage level at the inverter output node NY has a logic high level. Hence, the PMOS transistors M5 and M3' are turned on, the NMOS transistor M4' is turned off, the PMOS transistor M2' is turned off, and the PMOS transistor M1 may be turned on by the bias voltage VBIAS. When an ESD event SESD occur, the voltage level at the inverter output node NY is pulled low to generate/assert the ESD trigger signal STRIG'. Hence, the PMOS transistor M2' and the NMOS transistor M4' are turned on, and the control node of the PMOS transistor M1' is pulled low via the NMOS transistor M4'. A discharging path is created between the reference voltages VCC18 and the VSS. Since a person skilled in the art can readily understand the operation of the ESD protection circuit 400 after reading above paragraphs directed to the ESD protection circuit 200/300, further description is omitted here for brevity.

Those skilled in the art will readily observe that numerous modifications and alterations of the device and method may be made while retaining the teachings of the invention. Accordingly, the above disclosure should be construed as limited only by the metes and bounds of the appended claims.

**Claims**

1.　An electrostatic discharge, hereinafter ESD, protection circuit (100, 200, 300, 400), comprising:

an ESD detection circuit (102, 202, 402), configured to detect occurrence of an ESD event in a normal mode, wherein the ESD detection circuit (102, 202, 402) generates an ESD trigger signal ($S_{TRIG}$, $S_{TRIG'}$) when the ESD event is detected;

an ESD clamp circuit (104, 204, 304, 404), configured to perform a discharge operation in response to the ESD trigger signal ($S_{TRIG}$, $S_{TRIG'}$) in an ESD mode, wherein the ESD clamp circuit (104, 204, 304, 404) comprises:

> a first transistor (107, M1, M1'), having a first connection terminal (N11) coupled to a first power rail (20), a control terminal (N13), and a second connection terminal (N12), wherein a bias voltage ($V_{BIAS}$) is supplied to the control terminal (N13) of the first transistor (107, M1, M1') in the normal mode; and
> a second transistor (108, M2, M2'), having a first connection terminal (N21) coupled to the second connection terminal (N12) of the first transistor (107, M1, M1'), a control terminal (N23), and a second connection terminal (N22) coupled to a second power rail (30), wherein the ESD trigger signal ($S_{TRIG}$, $S_{TRIG'}$) is transmitted to the control terminal (N23) of the second transistor (108, M2, M2'); and

a leakage current reduction circuit (106, 206, 406), configured to provide the bias voltage ($V_{BIAS}$) to the first transistor (107, M1, M1');

wherein the ESD detection circuit (102, 202, 402) comprises:

> a low-pass filter (212, 412), coupled between the first power rail (20) and the second power rail (30); and
> an inverter (214), having an input terminal configured to receive a filter output (SLPF, SLPF') of the low-pass filter (212, 412) and an output terminal (NY) coupled to the control terminal (N23) of the second transistor (M2); **characterised in that**

the leakage current reduction circuit (106, 206, 406) comprises:

> a third transistor (M3, M3'), having a first connection terminal (N31) configured to receive the bias voltage ($V_{BIAS}$), a control terminal (N33) coupled to the input terminal of the inverter (214), and a second connection terminal (N32) coupled to the control terminal (N13) of the first transistor (M1); and
> a fourth transistor (M4, M4'), having a first connection terminal (N41) coupled to the control terminal (N13) of the first transistor (M1), a control terminal (N43) coupled to the input terminal of the inverter (214), and a second connection terminal (N42) coupled to the control terminal (N23) of the second transistor (M2).

**2.** The ESD protection circuit (100, 200, 300, 400) of claim 1, **characterized in that** a first reference voltage (VCC18) supplied by the first power rail (20) is higher than a second reference voltage (VSS) supplied by the second power rail (30), and the bias voltage ($V_{BIAS}$) is between the first reference voltage (VCC18) and the second reference voltage (VSS).

**3.** The ESD protection circuit (100, 200, 300, 400) of claim 2, **characterized in that** the first reference voltage (VCC18) is a supply voltage, the second reference voltage (VSS) is a ground voltage, and the bias voltage ($V_{BIAS}$) is within a voltage range from 0.25*VCC to 0.75*VCC, where VCC is the supply voltage.

**4.** The ESD protection circuit (100, 200, 300, 400) of claim 1, **characterized in that** the first reference voltage is a supply voltage being 1.8V, and each of the first transistor (107, M1, M1') and the second transistor (108, M2, M2') is a Fin Field-Effect Transistor.

**5.** The ESD protection circuit (100, 200, 300, 400) of claim 1, **characterized in that** the leakage current reduction circuit (106, 206, 406) further comprises: a voltage divider (218), configured to receive a reference voltage (VCC09) from a power source (10), generate a divided voltage ($V_{DIV}$) according to the reference voltage (VCC09), and output the divided voltage ($V_{DIV}$) to set the bias voltage ($V_{BIAS}$).

**6.** The ESD protection circuit (100, 200, 300, 400) of claim 1, **characterized in that** the leakage current reduction circuit (106, 206, 406) receives a reference voltage (VCC09) from a power source (10), and directly sets the bias voltage ($V_{BIAS}$) by the reference voltage (VCC09).

**7.** The ESD protection circuit (100, 200, 300, 400) of claim 1, **characterized in that** a gate oxide thickness of the second transistor (108, M2, M2') is smaller than a gate oxide thickness of the first transistor (107, M1, M1'), or a gate oxide thickness of the second transistor (108, M2, M2') is equal to a gate oxide thickness of the first transistor (107, M1, M1').

**8.** The ESD protection circuit (100, 200, 300, 400) of claim 1, **characterized in that** in the normal mode, the third transistor (M3, M3') is turned on and the fourth transistor (M4, M4') is turned off; and in the ESD mode, the fourth transistor (M4, M4') is turned on.

9. An electrostatic discharge, hereinafter ESD, protection method performed by an ESD protection circuit (100, 200, 300, 400) according to any of the preceding claims, **characterized by**:

   detecting occurrence of the ESD event in the normal mode;
   when the ESD event is detected, generating the ESD trigger signal ($S_{TRIG}$, $S_{TRIG'}$) for triggering the ESD clamp circuit (104, 204, 304, 404) to perform the discharge operation in the ESD mode; and
   in the normal mode, supplying the bias voltage ($V_{BIAS}$) to the control terminal (N13) of the first transistor (107, M1, M1') for reducing a leakage current of the first transistor (107, M1, M1').

10. The ESD protection method of claim 9, **characterized in that** a first reference voltage (VCC18) supplied by the first power rail (20) is higher than a second reference voltage (VSS) supplied by the second power rail (30), and the bias voltage ($V_{BIAS}$) is between the first reference voltage (VCC18) and the second reference voltage (VSS).

11. The ESD protection method of claim 10, **characterized in that** the first reference voltage (VCC18) is a supply voltage, the second reference voltage (VSS) is a ground voltage, and the bias voltage ($V_{BIAS}$) is within a voltage range from 0.25*VCC to 0.75*VCC, where VCC is the supply voltage.

12. The ESD protection method of claim 9, **characterized in that** the first reference voltage (VCC18) is a supply voltage being 1.8V, and each of the first transistor (107, M1, M1') and the second transistor (108, M2, M2') is a Fin Field-Effect Transistor.

13. The ESD protection method of claim 9, **characterized in that** supplying the bias voltage ($V_{BIAS}$) to the control terminal (N13) of the first transistor (107, M1, M1') comprises:

    receiving a reference voltage (VCC09) from a power source;
    performing a voltage dividing operation to generate a divided voltage ($V_{DIV}$) according to the reference voltage (VCC09); and
    outputting the divided voltage ($V_{DIV}$) to set the bias voltage ($V_{BIAA}$).

14. The ESD protection method of claim 9, **characterized in that** supplying the bias voltage ($V_{BIAS}$) to the control terminal (N13) of the first transistor comprises (107, M1, M1'):

   receiving a reference voltage (VCC09) from a power source (10); and
   directly setting the bias voltage ($V_{BIAS}$) by the reference voltage (VCC09).

**Patentansprüche**

1. Elektrostatische-Entladung-, nachfolgend ESD-, Schutzschaltung (100, 200, 300, 400), aufweisend:

   eine ESD-Erfassungsschaltung (102, 202, 402), die eingerichtet ist, ein Auftreten eines ESD-Ereignisses in einer regulären Betriebsart zu erfassen, wobei die ESD-Erfassungsschaltung (102, 202, 402) ein ESD-Auslösesignal ($S_{TRIG}$, $S_{TRIG'}$) generiert, wenn das ESD-Ereignis erfasst wird;
   eine ESD-Klemmschaltung (104, 204, 304, 404), die eingerichtet ist, einen Entladevorgang als Reaktion auf das ESD-Auslösesignal ($S_{TRIG}$, $S_{TRIG'}$) in einer ESD-Betriebsart auszuführen, wobei die ESD-Klemmschaltung (104, 204, 304, 404) aufweist:

       einen ersten Transistor (107, M1, M1'), der einen ersten Verbindungsanschluss (N11), der mit einer ersten Stromschiene (20) verbunden ist, einen Steueranschluss (N13) und einen zweiten Verbindungsanschluss (N12) aufweist, wobei in der regulären Betriebsart eine Bias-Spannung ($V_{BIAS}$) an den Steueranschluss (N13) des ersten Transistors (107, M1, M1') bereitgestellt wird; und
       einen zweiten Transistor (108, M2, M2'), der einen ersten Verbindungsanschluss (N21), der mit dem zweiten Verbindungsanschluss (N12) des ersten Transistors (107, M1, M1') verbunden ist, einen Steueranschluss (N23) und einen zweiten Verbindungsanschluss (N22), der mit einer zweiten Stromschiene (30) verbunden ist, aufweist, wobei das ESD-Auslösesignal ($S_{TRIG}$, $S_{TRIG'}$) an den Steueranschluss (N23) des zweiten Transistors (108, M2, M2') übertragen wird; und

   eine Leckstromreduzierungsschaltung (106, 206, 406), die eingerichtet ist, die Bias-Spannung ($V_{BIAS}$) an den ersten Transistor (107, M1, M1') bereitzustellen;
   wobei die ESD-Erfassungsschaltung (102, 202, 402) aufweist:

       ein Tiefpassfilter (212, 412), das zwischen der ersten Stromschiene (20) und der zweiten Stromschiene (30) angeschlossen ist; und

einen Inverter (214), der einen Eingangsanschluss, der eingerichtet ist, einen Filterausgang (SLPF, SLPF') des Tiefpassfilters (212, 412) zu empfangen, und einen Ausgangsanschluss (NY), der mit dem Steueranschluss (N23) des zweiten Transistors (M2) verbunden ist, aufweist;

**dadurch gekennzeichnet, dass**

die Leckstromreduzierungsschaltung (106, 206, 406) aufweist:

einen dritten Transistor (M3, M3'), der einen ersten Verbindungsanschluss (N31), der eingerichtet ist, die Bias-Spannung ($V_{BIAS}$) zu empfangen, einen Steueranschluss (N33), der mit dem Eingangsanschluss des Inverters (214) verbunden ist, und einen zweiten Verbindungsanschluss (N32), der mit dem Steueranschluss (N13) des ersten Transistors (M1) verbunden ist, aufweist; und

einen vierten Transistor (M4, M4'), der einen ersten Verbindungsanschluss (N41), der mit dem Steueranschluss (N13) des ersten Transistors (M1) verbunden ist, einen Steueranschluss (N43), der mit dem Eingangsanschluss des Inverters (214) verbunden ist, und einen zweiten Verbindungsanschluss (N42), der mit dem Steueranschluss (N23) des zweiten Transistors (M2) verbunden ist, aufweist.

2. ESD-Schutzschaltung (100, 200, 300, 400) gemäß Anspruch 1, **dadurch gekennzeichnet, dass** eine erste Referenzspannung (VCC18), die durch die erste Stromschiene (20) bereitgestellt wird, höher ist als eine zweite Referenzspannung (VSS), die durch die zweite Stromschiene (30) bereitgestellt wird, und die Bias-Spannung ($V_{BIAS}$) zwischen der ersten Referenzspannung (VCC18) und der zweiten Referenzspannung (VSS) liegt.

3. ESD-Schutzschaltung (100, 200, 300, 400) gemäß Anspruch 2, **dadurch gekennzeichnet, dass** die erste Referenzspannung (VCC18) eine Versorgungsspannung ist, die zweite Referenzspannung (VSS) eine Masse-Spannung ist und die Bias-Spannung ($V_{BIAS}$) innerhalb eines Spannungsbereichs von 0,25*VCC bis 0,75*VCC liegt, wobei VCC die Versorgungsspannung ist.

4. ESD-Schutzschaltung (100, 200, 300, 400) gemäß Anspruch 1, **dadurch gekennzeichnet, dass** die erste Referenzspannung eine Versorgungsspannung ist, die 1,8V ist, und jeder des ersten Transistors (107, M1, M1') und des zweiten Transistors (108, M2, M2') ein Fin-Feldeffekttransistor ist.

5. ESD-Schutzschaltung (100, 200, 300, 400) gemäß Anspruch 1, **dadurch gekennzeichnet, dass** die Leckstromreduzierungsschaltung (106, 206, 406) weiter aufweist:

einen Spannungsteiler (218), der eingerichtet ist, eine Referenzspannung (VCC09) von einer Energiequelle (10) zu empfangen, eine geteilte Spannung ($V_{DIV}$) gemäß der Referenzspannung (VCC09) zu generieren und die geteilte Spannung ($V_{DIV}$) auszugeben, um die Bias-Spannung ($V_{BIAS}$) einzustellen.

6. ESD-Schutzschaltung (100, 200, 300, 400) gemäß Anspruch 1, **dadurch gekennzeichnet, dass** die Leckstromreduzierungsschaltung (106, 206, 406) eine Referenzspannung (VCC09) von einer Energiequelle (10) empfängt und die Bias-Spannung ($V_{BIAS}$) direkt durch die Referenzspannung (VCC09) einstellt.

7. ESD-Schutzschaltung (100, 200, 300, 400) gemäß Anspruch 1, **dadurch gekennzeichnet, dass** eine Gate-Oxiddicke des zweiten Transistors (108, M2, M2') kleiner ist als eine Gate-Oxiddicke des ersten Transistors (107, M1, M1') oder eine Gate-Oxiddicke des zweiten Transistors (108, M2, M2') gleich einer Gate-Oxiddicke des ersten Transistors (107, M1, M1') ist.

8. ESD-Schutzschaltung (100, 200, 300, 400) gemäß Anspruch 1, **dadurch gekennzeichnet, dass** in der regulären Betriebsart der dritte Transistor (M3, M3') eingeschaltet ist und der vierte Transistor (M4, M4') ausgeschaltet ist; und in der ESD-Betriebsart der vierte Transistor (M4, M4') eingeschaltet ist.

9. Elektrostatische-Entladung-, nachfolgend ESD-, Schutzverfahren, das durch eine ESD-Schutzschaltung (100, 200, 300, 400) gemäß einem der vorstehenden Ansprüche ausgeführt wird, **gekennzeichnet durch**:

Erfassen eines Auftretens des ESD-Ereignisses in der regulären Betriebsart; wenn das ESD-Ereignis erfasst wird, Generieren des ESD-Auslösesignals ($S_{TRIG}$, $S_{TRIG'}$) zum Auslösen der ESD-Klemmschaltung (104, 204, 304, 404), um den Entladevorgang in der ESD-Betriebsart auszuführen; und in der regulären Betriebsart Bereitstellen der Bias-Spannung ($V_{BIAS}$) an den Steueranschluss (N13) des ersten Transistors (107, M1, M1') zum Reduzieren eines Leckstroms des ersten Transistors (107, M1, M1').

**10.** ESD-Schutzverfahren gemäß Anspruch 9, **dadurch gekennzeichnet, dass** eine erste Referenzspannung (VCC18), die durch die erste Stromschiene (20) bereitgestellt wird, höher ist als eine zweite Referenzspannung (VSS), die durch die zweite Stromschiene (30) bereitgestellt wird, und die Bias-Spannung (V$_{BIAS}$) zwischen der ersten Referenzspannung (VCC18) und der zweiten Referenzspannung (VSS) liegt.

**11.** ESD-Schutzverfahren gemäß Anspruch 10, **dadurch gekennzeichnet, dass** die erste Referenzspannung (VCC18) eine Versorgungsspannung ist, die zweite Referenzspannung (VSS) eine Masse-Spannung ist und die Bias-Spannung (V$_{BIAS}$) innerhalb eines Spannungsbereichs von 0,25*VCC bis 0,75*VCC liegt, wobei VCC die Versorgungsspannung ist.

**12.** ESD-Schutzverfahren gemäß Anspruch 9, **dadurch gekennzeichnet, dass** die erste Referenzspannung (VCC18) eine Versorgungsspannung ist, die 1,8V ist, und jeder des ersten Transistors (107, M1, M1') und des zweiten Transistors (108, M2, M2') ein Fin-Feldeffekttransistor ist.

**13.** ESD-Schutzverfahren gemäß Anspruch 9, **dadurch gekennzeichnet, dass** ein Bereitstellen der Bias-Spannung (V$_{BIAS}$) an den Steueranschluss (N13) des ersten Transistors (107, M1, M1') umfasst:

Empfangen einer Referenzspannung (VCC09) von eine Energiequelle;
Ausführen eines Spannungsteilungsvorgangs, um eine geteilte Spannung (V$_{DIV}$) gemäß der Referenzspannung (VCC09) zu generieren; und
Ausgeben der geteilten Spannung (V$_{DIV}$), um die Bias-Spannung (V$_{BIAA}$) einzustellen.

**14.** ESD-Schutzverfahren gemäß Anspruch 9, **dadurch gekennzeichnet, dass** ein Bereitstellen der Bias-Spannung (V$_{BIAS}$) an den Steueranschluss (N13) des ersten Transistors (107, M1, M1') umfasst:

Empfangen einer Referenzspannung (VCC09) von eine Energiequelle (10); und
direktes Einstellen der Bias-Spannung (V$_{BIAS}$) durch die Referenzspannung (VCC09).

## Revendications

**1.** Circuit de protection contre les décharges électrostatiques, ci-après dénommées ESD, (100, 200, 300, 400), comprenant :

un circuit de détection ESD (102, 202, 402), configuré pour détecter l'occurrence d'un événement ESD en mode normal, où le circuit de détection ESD (102, 202, 402) génère un signal de déclenchement ESD (S$_{TRIG}$, S$_{TRIG'}$) lorsque l'événement ESD est détecté ;
un circuit de fixation ESD (104, 204, 304, 404), configuré pour effectuer une opération de décharge en réponse au signal de déclenchement ESD (S$_{TRIG}$, S$_{TRIG'}$) en mode ESD, où le circuit de fixation ESD (104, 204, 304, 404) comprend :

un premier transistor (107, M1, M1'), ayant une première borne de liaison (N11) couplée à un premier rail d'alimentation (20), une borne de commande (N13) et une deuxième borne de liaison (N12), où une tension de polarisation (V$_{BIAS}$) est fournie à la borne de commande (N13) du premier transistor (107, M1, M1') en mode normal ; et
un deuxième transistor (108, M2, M2') ayant une première borne de liaison (N21) couplée à la deuxième borne de liaison (N12) du premier transistor (107, M1, M1'), une borne de commande (N23), et une deuxième borne de liaison (N22) couplée à un deuxième rail d'alimentation (30), où le signal de déclenchement ESD (S$_{TRIG}$, S$_{TRIG'}$) est transmis à la borne de commande (N23) du deuxième transistor (108, M2, M2') ; et

un circuit de réduction de courant de fuite (106, 206, 406), configuré pour fournir la tension de polarisation (V$_{BIAS}$) au premier transistor (107, M1, M1') ;
dans lequel le circuit de détection ESD (102, 202, 402) comprend :

un filtre passe-bas (212, 412), couplé entre le premier rail d'alimentation (20) et le deuxième rail d'alimentation (30) ; et
un onduleur (214) ayant une borne d'entrée configurée pour recevoir une sortie de filtre (SLPF, SLPF') du filtre passe-bas (212, 412) et une borne de sortie (NY) couplée à la borne de commande (N23) du deuxième transistor (M2) ;

**caractérisé en ce que** le circuit de réduction de courant de fuite (106, 206, 406) comprend :

un troisième transistor (M3, M3') ayant une première borne de liaison (N31) configurée pour recevoir la tension de polarisation (V$_{BIAS}$), une borne de commande (N33) couplée à la borne d'entrée de l'onduleur (214), et une deuxième borne de liaison (N32) couplée à la borne de commande (N13) du premier transistor (M1) ; et un quatrième transistor (M4, M4') ayant une première borne de liaison (N41) couplée à la borne de commande (N13) du premier transistor (M1), une borne de commande (N43) couplée à la borne d'entrée de l'onduleur (214) et une deuxième borne de liaison (N42) couplée à la borne de commande (N23) du deuxième transistor (M2).

2. Circuit de protection contre les ESD (100, 200, 300, 400) de la revendication 1, **caractérisé en ce qu'**une première tension de référence (VCC18) fournie par le premier rail d'alimentation (20) est supérieure à une deuxième tension de référence (VSS) fournie par le deuxième rail d'alimentation (30) et la tension de polarisation ($V_{BIAS}$) est comprise entre la première tension de référence (VCC18) et la deuxième tension de référence (VSS).

3. Circuit de protection contre les ESD (100, 200, 300, 400) de la revendication 2, **caractérisé en ce que** la première tension de référence (VCC18) est une tension d'alimentation, la deuxième tension de référence (VSS) est une tension de mise à la terre et la tension de polarisation ($V_{BIAS}$) est comprise dans une plage de tension allant de 0,25*VCC à 0,75*VCC, où VCC est la tension d'alimentation.

4. Circuit de protection contre les ESD (100, 200, 300, 400) de la revendication 1, **caractérisé en ce que** la première tension de référence est une tension d'alimentation de 1,8 V, et chacun du premier transistor (107, M1, M1') et du deuxième transistor (108, M2, M2') est un transistor à effet de champ à ailette.

5. Circuit de protection contre les ESD (100, 200, 300, 400) de la revendication 1, **caractérisé en ce que** le circuit de réduction de courant de fuite (106, 206, 406) comprend en outre : un diviseur de tension (218), configuré pour recevoir une tension de référence (VCC09) à partir d'une source d'alimentation (10), générer une tension divisée ($V_{DIV}$) selon la tension de référence (VCC09), et délivrer en sortie la tension divisée ($V_{DIV}$) pour régler la tension de polarisation ($V_{BIAS}$).

6. Circuit de protection contre les ESD (100, 200, 300, 400) de la revendication 1, **caractérisé en ce que** le circuit de réduction de courant de fuite (106, 206, 406) reçoit une tension de référence (VCC09) à partir d'une source d'alimentation (10), et règle directement la tension de polarisation ($V_{BIAS}$) par la tension de référence (VCC09).

7. Circuit de protection contre les ESD (100, 200, 300, 400) de la revendication 1, **caractérisé en ce qu'**une épaisseur d'oxyde de grille du deuxième transistor (108, M2, M2') est inférieure à une épaisseur d'oxyde de grille du premier transistor (107, M1, M1'), ou une épaisseur d'oxyde de grille du deuxième transistor (108, M2, M2') est égale à une épaisseur d'oxyde de grille du premier transistor (107, M1, M1').

8. Circuit de protection contre les ESD (100, 200, 300, 400) de la revendication 1, **caractérisé en ce qu'**en mode normal, le troisième transistor (M3, M3') est allumé et le quatrième transistor (M4, M4') est éteint ; et en mode ESD, le quatrième transistor (M4, M4') est allumé.

9. Procédé de protection contre les décharges électrostatiques, ci-après dénommées ESD, effectué par un circuit de protection contre les ESD (100, 200, 300, 400) selon l'une des revendications précédentes, **caractérisé par** le fait :

   de détecter l'occurrence de l'événement ESD en mode normal ; lorsque l'événement ESD est détecté, de générer le signal de déclenchement ESD ($S_{TRIG}$, $S_{TRIG}'$) pour déclencher le circuit de fixation ESD (104, 204, 304, 404) afin d'effectuer l'opération de décharge en mode ESD ; et en mode normal, d'alimenter en tension de polarisation ($V_{BIAS}$) la borne de commande (N13) du premier transistor (107, M1, M1') pour réduire un courant de fuite du premier transistor (107, M1, M1').

10. Procédé de protection contre les ESD de la revendication 9, **caractérisé en ce qu'**une première tension de référence (VCC18) fournie par le premier rail d'alimentation (20) est supérieure à une deuxième tension de référence (VSS) fournie par le deuxième rail d'alimentation (30), et la tension de polarisation ($V_{BIAS}$) est comprise entre la première tension de référence (VCC18) et la deuxième tension de référence (VSS).

11. Procédé de protection contre les ESD de la revendication 10, **caractérisé en ce que** la première tension de référence (VCC18) est une tension d'alimentation, la deuxième tension de référence (VSS) est une tension de mise à la terre, et la tension de polarisation ($V_{BIAS}$) est comprise dans une plage de tension allant de 0,25*VCC à 0,75*VCC, où VCC est la tension d'alimentation.

12. Procédé de protection contre les ESD de la revendication 9, **caractérisé en ce que** la première tension de référence (VCC18) est une tension d'alimentation de 1,8V, et chacun du premier transistor (107, M1, M1') et du deuxième transistor (108, M2, M2') est un transistor à effet de champ à ailette.

**13.** Procédé de protection contre les ESD de la revendication 9, **caractérisé en ce que** l'alimentation en tension de polarisation ($V_{BIAS}$) de la borne de commande (N13) du premier transistor (107, M1, M1') comprend le fait :

de recevoir une tension de référence (VCC09) à partir d'une source d'alimentation ;
d'effectuer une opération de division de tension pour générer une tension divisée ($V_{DIV}$) en fonction de la tension de référence (VCC09) ; et
de délivrer en sortie la tension divisée ($V_{DIV}$) pour régler la tension de polarisation ($V_{BIAA}$).

**14.** Procédé de protection contre les ESD de la revendication 9, **caractérisé en ce que** l'alimentation en tension de polarisation ($V_{BIAS}$) de la borne de commande (N13) du premier transistor (107, M1, M1') comprend le fait :

de recevoir une tension de référence (VCC09) à partir d'une source d'alimentation (10) ; et
de régler directement la tension de polarisation ($V_{BIAS}$) par la tension de référence (VCC09).

FIG. 1

EP 3 200 228 B1

FIG. 2

FIG. 3

FIG. 4

EP 3 200 228 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013027820 A1
- US 20080297960 A1
- US 20060072267 A1
- US 20140063665 A1